Europäisches Patentamt

European Patent Office

Office européen des brevets

(19)

(11) EP 1 598 871 A1

(12) **EUROPEAN PATENT APPLICATION**
published in accordance with Art. 158(3) EPC

(43) Date of publication:
**23.11.2005 Bulletin 2005/47**

(51) Int Cl.7: **H01L 27/04**, H01L 27/10, H01G 4/33, H01G 4/12, C04B 35/453, C01G 29/00

(21) Application number: **04713201.4**

(22) Date of filing: **20.02.2004**

(86) International application number:
**PCT/JP2004/001979**

(87) International publication number:
**WO 2004/077565 (10.09.2004 Gazette 2004/37)**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **27.02.2003 JP 2003050213**

(71) Applicant: **TDK Corporation
Chuo-ku, Tokyo 103-8272 (JP)**

(72) Inventor: **SAKASHITA, Yukio
Chuo-ku, Tokyo 103-8272 (JP)**

(74) Representative: **HOFFMANN EITLE
Patent- und Rechtsanwälte
Arabellastrasse 4
81925 München (DE)**

(54) **THIN-FILM CAPACITIVE ELEMENT AND ELECTRONIC CIRCUIT OR ELECTRONIC EQUIPMENT INCLUDING THE SAME**

(57) A thin film capacitive element according to the present invention includes between a first electrode layer and a second electrode layer a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$, where a symbol $m$ is a positive integer, a symbol $A$ is at least one element selected from a group consisting of sodium, potassium, lead, barium, strontium, calcium and bismuth, and a symbol $B$ is at least one element selected from a group consisting of iron, cobalt, chromium, gallium, titanium, niobium, tantalum, antimony, vanadium, molybdenum and tungsten.

The thin film capacitive element having the above identified configuration can be made thin and has an excellent temperature compensating characteristic.

FIG. 1

## Description

## BACKGROUND OF THE INVENTION

The present invention relates to a thin film capacitive element, and an electronic circuit and an electronic device including the same and, particularly, to a thin film capacitive element which can be made thin and has an excellent temperature compensating characteristic, and an electronic circuit and an electronic device including the thin film capacitive element.

## DESCRIPTION OF THE PRIOR ART

Since it is preferable for an electronic circuit included in an electronic device to have a low temperature dependency, numerous attempts for reducing the temperature dependency of an electronic circuit by controlling the electrostatic capacitance temperature coefficient of a capacitive element included in the electronic circuit has been recently made.

For example, each of Japanese Patent Application Laid Open No. 2002-289462, Japanese Patent Application Laid Open No. 2002-75783 and Japanese Patent Application Laid Open No. 2002-252143 proposes a thin film capacitive element whose electrostatic capacitance temperature coefficient is controlled in a desired manner by forming a plurality of dielectric layers of dielectric materials having different electrostatic capacitance temperature coefficients between an upper electrode and a lower electrode.

However, in the case of forming dielectric materials having different electrostatic capacitance temperature coefficients, thereby controlling the electrostatic capacitance temperature coefficient of a thin film capacitive element, not only does the process for fabricating the thin film capacitive element become complicated and the thickness of the thin film capacitive element inevitably increase but it also becomes necessary to precisely control the thickness of each of the dielectric layers for controlling the electrostatic capacitance temperature coefficient of the thin film capacitive element in a desired manner.

## SUMMARY OF THE INVENTION

It is therefore an object of the present invention to provide a thin film capacitive element which can be made thin and has an excellent temperature compensating characteristic, and an electronic circuit and an electronic device including the thin film capacitive element.

The inventor of the present invention vigorously pursued a study for accomplishing the above object and, as a result, made the surprising discovery that the electrostatic capacitance temperature coefficient of a thin film capacitive element including a dielectric layer formed of a dielectric material containing a bismuth layer structured compound having a specific stoichiometric composition depended upon the degree of the orientation of the bismuth layer structured compound in the [001] direction, namely, the degree of the orientation of the bismuth layer structured compound in the c axis direction thereof, and that the electrostatic capacitance temperature coefficient of a thin film capacitive element could be controlled in a desired manner by controlling the degree of the orientation of the bismuth layer structured compound contained in the dielectric layer in the c axis direction thereof.

The present invention is based on these findings and according to the present invention, the above object of the present invention can be accomplished by a thin film capacitive element including between a first electrode layer and a second electrode layer a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$, where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined.

In the present invention, the dielectric material containing the bismuth layer structured compound may contain unavoidable impurities.

According to the present invention, it is possible to control the degree of orientation in the [001] direction of the bismuth layer structured compound contained in a dielectric layer, namely, the degree of the orientation of the bismuth layer structured compound in the c axis direction thereof when the dielectric layer is formed, thereby determining the electrostatic capacitance temperature coefficient of a thin film capacitive element containing the dielectric layer to a desired value and it is therefore possible to control the temperature coefficient of an electronic circuit into which the thin film capacitive element is incorporated in a desired manner and further control the temperature coefficient of an electronic device into which the electronic circuit including the thin film capacitive element is incorporated in a desired manner.

The degree of c axis orientation of the bismuth structured compound can be controlled by selecting the kind of substrate used for the thin film capacitive element, the kind of electrode used for the thin film capacitive element, the process for forming the thin film capacitive element and the conditions for forming the thin film capacitive element.

For example, the degree of $c$ axis orientation of a bismuth layer structured compound can be improved by selecting a single crystal substrate oriented in the [001] direction or an electrode oriented in the [001] direction and on the other hand, the degree of c axis orientation of a bismuth layer structured compound can be lowered by selecting an amorphous substrate or an amorphous electrode.

Further, the degree of $c$ axis orientation of a bismuth layer structured compound can be improved by selecting a metal organic chemical vapor deposition process (MOCVD), a pulsed laser deposition process (PLD), a vacuum deposition process or the like as the process for forming the dielectric layer, and on the other hand, the degree of $c$ axis orientation of a bismuth layer structured compound can be lowered by selecting a chemical solution deposition process (CSD process) such as a metal-organic decomposition process (MOD) and a sol-gel process or the like.

Furthermore, in the case of forming a dielectric layer using a chemical solution deposition process, the degree of $c$ axis orientation of a bismuth layer structured compound can be controlled by controlling the coating conditions, provisional baking conditions and baking conditions for forming the dielectric layer.

In the present invention, the degree of c axis orientation of a bismuth layer structured compound is defined by the following formula (1).

$$F = (P - P_0)/(1 - P_0) \times 100 \qquad (1)$$

In formula (1), $P_0$ is defined as a $c$ axis orientation ratio of a bismuth layer structured compound whose orientation is completely random, namely, the ratio of the sum $\sum I_0 (00\mathit{1}l)$ of reflection intensities $I_o (00\mathit{1})$ from the surface of [00$\mathit{1}$] of the bismuth layer structured compound whose orientation is completely random to the sum $\sum I_0 (hkl)$ of reflection intensities $I_0 (hkl)$ from the respective crystal surfaces of [$hkl$] thereof ($\sum I_0 (00\mathit{l}l)/ \sum I_0 (hkl)$), and $P$ is defined as the $c$ axis orientation ratio of the bismuth layer structured compound calculated using the X-ray diffraction intensity thereof, namely, the ratio of the sum $\sum I(00\mathit{l})$ of reflection intensities $I(00\mathit{1})$ from the surface of [00$\mathit{1}$] of the bismuth layer structured compound to the sum $\sum I (hkl)$ of reflection intensities $I (hkl)$ from the respective crystal surfaces of [$hkl$] thereof ($\sum I (00\mathit{l})/ \sum I (hkl)$). The symbols $h, k$ and $l$ can each assume an arbitrary integer value equal to or larger than 0.

In the above formula (1), since $P_0$ is a known constant, when the sum $\sum I (00\mathit{l})$ of reflection intensities $I (00\mathit{1})$ from the surface of [00$\mathit{1}$] of the bismuth layer structured compound and the sum $\sum I (hkl)$ of reflection intensities $I (hkl)$ from the respective crystal surfaces of [$hkl$] are equal to each other, the degree $F$ of the c axis orientation of the bismuth layer structured compound is equal to 100 %.

The bismuth layer structured compound has a layered structure formed by alternately laminating perovskite layers each including perovskite lattices made of (m - 1) $ABO_3$ and $(Bi_2O_2)^{2+}$ layers.

The c axis of the bismuth layer structured compound means the direction obtained by connecting the pair of $(Bi_2O_2)^{2+}$ layers, namely, the [001] direction.

In the present invention, the symbol $m$ in the stoichiometric compositional formula is not particularly limited insofar as it is a positive integer but the symbol m is preferably an even number. In the case where the symbol $m$ is an even number, the dielectric thin film 6 has a mirror plane of symmetry perpendicular to the $c$ axis, so that spontaneous polarization components in the $c$ axis direction cancel each other on opposite sides of the mirror plane of symmetry, whereby the dielectric thin film has no polarization axis in the $c$ axis direction. As a result, it is possible to maintain the paraelectric property of the dielectric thin film, to improve the temperature coefficient of the dielectric constant and to lower loss. If the symbol $m$ is large, the dielectric constant of the dielectric thin film 6 tends to increase.

In the present invention, the symbol $m$ in the stoichiometric compositional formula is preferably 2, 4, 6 or 8 and the symbol $m$ is more preferably 2 or 4.

In the present invention, it is preferable for the electrostatic capacitance temperature coefficient of the bismuth layer structured compound to fall in the range of from 1000 ppm/K to -700 ppm/K.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be accomplished by a thin film capacitive element including a dielectric layer formed of a dielectric material containing a bismuth layer structured compound having a composition represented by the stoichiometric compositional formula: $x\mathrm{SbBi_4Ti_4O_{15}}$-(1 - $x$) $M\mathrm{Bi_4Ti_4O_{15}}$ between a first electrode layer and a second electrode layer, where the symbol $M$ is at least one element selected from calcium, barium or lead and the symbol $x$ is equal to or larger than 0 and equal to or smaller than 1.

In a preferred aspect of the present invention, the dielectric layer contains a bismuth layer structured compound represented by the stoichiometric compositional formula: $\mathrm{SrBi_4Ti_4O_{15}}$.

In the present invention, it is preferable for the electrostatic capacitance temperature coefficient of a bismuth layer structured compound to fall in the range of from 800 ppm/K to -150 ppm/K.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic circuit including a thin film capacitive element including a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$ between a first electrode layer and a second electrode layer, where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined.

According to the present invention, since the electrostatic capacitance temperature coefficient of a thin film capacitive element in which a dielectric layer is formed of a dielectric material containing a bismuth layer structured compound having a composition represented by the above mentioned stoichiometric compositional formula depends upon the degree of orientation in the [001] direction of the bismuth layer structured compound contained in a dielectric layer, namely, the degree of the orientation of the bismuth layer structured compound in the $c$ axis direction thereof, it is possible to control the electrostatic capacitance temperature coefficient of a thin film capacitive element in a desired manner by controlling the degree of c axis orientation of the bismuth layer structured compound contained in a dielectric layer. Therefore, if a thin film capacitive element including a dielectric layer formed of a dielectric material containing the bismuth layer structured compound is incorporated into an electronic circuit, the temperature coefficient of the electronic circuit can be controlled in a desired manner.

In the present invention, it is preferable for the electrostatic capacitance temperature coefficient of a bismuth layer structured compound to fall in the range of from 1000 ppm/K to -700 ppm/K.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic circuit including a thin film capacitive element including a dielectric layer formed of a dielectric material containing a bismuth layer structured compound having a composition represented by the stoichiometric compositional formula: $xSbBi_4Ti_4O_{15} - (1 - x)MBi_4Ti_4O_{15}$ between a first electrode layer and a second electrode layer, where the symbol $M$ is at least one element selected from calcium, barium or lead and the symbol $x$ is equal to or larger than 0 and equal to or smaller than 1.

In a preferred aspect of the present invention, the dielectric layer contains a bismuth layer structured compound represented by the stoichiometric compositional formula: $SrBi_4Ti_4O_{15}$.

In the present invention, it is preferable for the electrostatic capacitance temperature coefficient of a bismuth layer structured compound to fall in the range of from 800 ppm/K to -150 ppm/K.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic device including a thin film capacitive element including a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$ between a first electrode layer and a second electrode layer, where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined.

According to the present invention, since the electrostatic capacitance temperature coefficient of a thin film capacitive element in which a dielectric layer is formed of a dielectric material containing a bismuth layer structured compound having a composition represented by the above mentioned stoichiometric compositional formula depends upon the degree of orientation in the [001] direction of the bismuth layer structured compound contained in a dielectric layer, namely, the degree of the orientation of the bismuth layer structured compound in the c axis direction thereof, it is possible to control the electrostatic capacitance temperature coefficient of a thin film capacitive element in a desired manner by controlling the degree of c axis orientation of the bismuth layer structured compound contained in a dielectric layer. Accordingly, if a thin film capacitive element including a dielectric layer formed of a dielectric material containing the bismuth layer structured compound is incorporated into an electronic circuit, the temperature coefficient of the electronic circuit can be controlled in a desired manner and it is therefore possible to control in a desired manner the temperature coefficient of an electronic device including an electronic circuit into which a thin film capacitive element including a dielectric layer formed of a dielectric material containing the bismuth layer structured compound is incorporated.

In the present invention, it is preferable for the electrostatic capacitance temperature coefficient of a bismuth layer structured compound to fall in the range of from 1000 ppm/K to -700 ppm/K.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In a study done by the inventor of the present invention, it was found that the above object of the present invention can be also accomplished by an electronic device including a thin film capacitive element including a dielectric layer formed of a dielectric material containing a bismuth layer structured compound having a composition represented by the stoichiometric compositional formula: $x$SbBi$_4$Ti$_4$O$_{15}$-(1 - $x$)$M$Bi$_4$Ti$_4$O$_{15}$ between a first electrode layer and a second electrode layer, where the symbol $M$ is at least one element selected from calcium, barium or lead and the symbol $x$ is equal to or larger than 0 and equal to or smaller than 1.

In a preferred aspect of the present invention, the dielectric layer contains a bismuth layer structured compound represented by the stoichiometric compositional formula: SrBi$_4$Ti$_4$O$_{15}$.

In the present invention, it is preferable for the electrostatic capacitance temperature coefficient of a bismuth layer structured compound to fall in the range of from 800 ppm/K to -150 ppm/K.

In a preferred aspect of the present invention, the bismuth layer structured compound contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In the present invention, the material used for forming a first electrode layer on the surface of which a dielectric layer is to be formed is not particularly limited and the first electrode layer can be formed of a metal such as platinum (Pt), ruthenium (Ru), rhodium (Rh), palladium (Pd), iridium (Ir), gold (Au), silver (Ag), copper (Cu), nickel (Ni) or the like, alloy containing at least one of these metals as a principal component, a conductive oxide such as NdO, NbO, ReO$_2$, RhO$_2$, OsO$_2$, IrO$_2$, RuO$_2$, ReO$_3$, SrMoO$_3$, SrRuO$_3$, CaRuO$_3$, SrVO$_3$, SrCrO$_3$, SrCoO$_3$, LaNiO$_3$, Nb doped SrTiO$_3$ or the like, a mixture of these, a superconductor having a superconductive layered bismuth structure such as Bi$_2$Sr$_2$CuO$_6$, or the like.

In the present invention, the first electrode layer on the surface of which a dielectric layer is to be formed can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like.

In the present invention, the first electrode layer on the surface of which a dielectric layer is to be formed may be oriented in the [001] direction, namely, the c axis direction or in a direction other than the [001] direction and further, the first electrode layer may be amorphous or unoriented.

In the present invention, the dielectric layer can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like.

In the present invention, it is preferable to form a dielectric layer using a metal organic chemical vapor deposition process (MOCVD), a pulsed laser deposition process (PLD) or a vacuum deposition process in order to improve the degree $F$ of the c axis orientation of the bismuth layer structured compound contained in the dielectric layer and on the other hand, it is preferable to form a dielectric layer using a chemical solution deposition process (CSD process) such as a metal-organic decomposition process (MOD) and a sol-gel process or the like in order to lower the degree $F$ of the c axis orientation of the bismuth layer structured compound contained in the dielectric layer.

In the present invention, a chemical solution deposition process means a thin film forming process including one or more coating steps, one or more provisional baking steps and one or more baking steps and includes a metal-organic decomposition process (MOD) and a sol-gel process. The chemical solution deposition process further includes a process for forming a thin film using an inorganic acid salt solution. Among these, a metal-organic decomposition process is most preferable.

During the process of forming the dielectric layer on the first electrode layer, the dielectric material containing a bismuth layer structured compound is epitaxially grown on the first electrode layer and the degree *F* of orientation of the bismuth layer structured compound in the [001] direction, namely, the c axis direction is determined by selecting the composition of the bismuth layer structured compound and the conditions for forming the dielectric layer.

In the case of forming the dielectric layer using a metal-organic decomposition process, a solution of a composition prepared for forming a thin film capacitive element and containing a bismuth layer structured compound is applied onto the first electrode layer to form a coating layer and the coating layer on the first electrode layer is baked, thereby forming a dielectric layer.

In the present invention, a dielectric layer is preferably formed by forming a coating layer on a first electrode layer, drying the coating layer, provisionally baking the coating layer at a temperature under which the coating layer cannot be crystallized and further baking the coating layer.

Alternatively, a dielectric layer may be formed by forming a coating layer on a first electrode layer, drying the coating layer, forming a new coating layer on the thus dried coating layer, drying the new coating layer, repeating these steps of forming new coating layers and drying them to form a coating layer having a predetermined thickness and then baking the coating layer. In this case, a dielectric layer may be formed by repeating coating and drying steps two or more times, provisionally baking the coating layer and finally baking the coating layer.

Alternatively, a dielectric layer may be formed by forming a coating layer on a first electrode layer, drying the coating layer, provisionally baking the coating layer, forming a new coating layer on the thus provisionally baked coating layer, drying the new coating layer, provisionally baking the new coating layer, repeating these steps of forming, drying and provisionally baking new coating layers to form a coating layer having a predetermined thickness and then baking the coating layer. In this case, a dielectric layer may be formed by repeating coating and provisional baking steps without drying the coating layers and finally baking the coating layer.

Alternatively, a dielectric layer may be formed by forming a coating layer on a first electrode layer, drying the coating layer, provisionally baking the coating layer and baking the coating layer, repeating these steps to form a coating layer having a predetermined thickness. In this case, a dielectric layer may be formed by repeating steps of coating, provisionally baking and baking a coating layer without drying the coating layer or a dielectric layer may be formed by repeating steps of coating, drying and baking a coating layer without provisionally baking the coating layer.

In the present invention, in the case of forming the dielectric layer using a metal-organic decomposition process, a solution of a composition prepared for forming a thin film capacitive element and containing a bismuth layer structured compound is applied onto the first electrode layer using a spin coating process or a dip coating process, preferably a spin coating process, thereby forming a coating layer.

In the present invention, a coating layer formed on a first electrode layer is preferably baked at a temperature of 700 to 900 °C which is a crystalline temperature of a bismuth layer structured compound.

In the present invention, a coating layer formed on a first electrode layer is preferably dried at a temperature of room temperature to 400 °C and more preferably dried at a temperature of 50 to 300 °C.

In the present invention, a coating layer formed on a first electrode layer is preferably provisionally baked at a temperature of 300 to 500 °C.

In the.present invention, after a dielectric layer has been formed on a first electrode layer, a second electrode layer is formed on the dielectric layer.

In the present invention, the material used for forming a second electrode layer is not particularly limited insofar as it is conductive and the second electrode layer can be formed of a metal such as platinum (Pt), ruthenium (Ru), rhodium (Rh), palladium (Pd), iridium (Ir), gold (Au), silver (Ag), copper (Cu), nickel (Ni) or the like, alloy containing at least one of these metal as a principal component, a conductive oxide such as NdO, NbO, $ReO_2$, $RhO_2$, $OsO_2$, $IrO_2$, $RuO_2$, $ReO_3$, $SrMoO_3$, $SrRuO_3$, $CaRuO_3$, $SrVO_3$, $SrCrO_3$, $SrCoO_3$, $LaNiO_3$, Nb doped $SrTiO_3$ or the like, a mixture of these, conductive glass such as ITO, or the like. Further, unlike the first electrode layer, since the second electrode layer can be formed at room temperature, a base metal such as iron (Fe), nickel (Ni) or the like, or an alloy such as WSi, MoSi or the like can be used for forming the second electrode layer.

In the present invention, the thickness of a second electrode layer is not particularly limited insofar as it can serve as the one of the electrodes of a thin film capacitive element and the second electrode layer can be formed so as to have a thickness of 10 to 10000 nm, for example.

In the present invention, the method used for forming a second electrode layer is not particularly limited and the second electrode layer can be formed using any of various thin film forming processes such as a vacuum deposition process, a sputtering process, a pulsed laser deposition process (PLD), a metal organic chemical vapor deposition process (MOCVD), a chemical solution deposition process (CSD process) such as a metal-organic decomposition process (MOD) and a sol-gel process or the like. Among these, a sputtering process is most preferable for forming the second electrode layer from the viewpoint of the thin film forming rate.

The above and other objects and features of the present invention will become apparent from the following description made with reference to the accompanying drawings.

**BRIEF DESCRIPTION OF THE DRAWING**

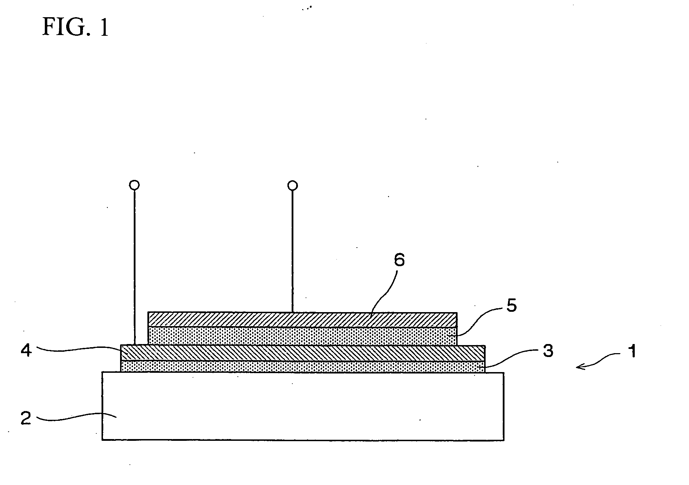

Figure 1 is a schematic cross-sectional view showing a thin film capacitive element which is a preferred embodiment of the present invention.

**DESCRIPTION OF THE PREFERRED EMBODIMENT**

A preferred embodiment of the present invention will now be described with reference to the accompanying drawing.

Figure 1 is a schematic cross-sectional view showing a thin film capacitive element which is a preferred embodiment of the present invention.

As shown in Figure 1, a thin film capacitive element 1 according to this embodiment includes a support substrate 2, and a barrier layer 3, a lower electrode layer 4, a dielectric layer 5 and an upper electrode layer 6 laminated on the support substrate 2 in this order.

In this embodiment, the support substrate 2 of the thin film capacitive element 1 is formed of silicon single crystal. The thickness of the support substrate 2 is set to 100 to 1000 $\mu$m, for example.

The thin film capacitive element 1 includes an insulating layer formed of silicon oxide on the support substrate 2.

The insulating layer 3 made of silicon oxide is formed by, for example, thermal oxidation of silicon.

As shown in Figure 1, the lower electrode layer 4 is formed on the insulating layer 3.

In this embodiment, the lower electrode layer 4 is formed of platinum.

The lower electrode layer 4 may be oriented in the [001] direction or in a direction other than the [001] direction. Further, the lower electrode layer 4 may be amorphous or may be unoriented.

The lower electrode layer 4 made of platinum is formed on the insulating layer 3 by, for example, using a sputtering process with argon gas as the sputtering gas and setting the temperatures of the support substrate 2 and the insulating layer 3 to 300 $^\circ$C or higher, preferably, 500 $^\circ$C or higher.

The thickness of the lower electrode layer 4 is not particularly limited and set to about 10 to 1000 nm, preferably, about 50 to 200 nm. In this embodiment, the lower electrode layer 4 is formed so as to have a thickness of 100 nm.

As shown in Figure 1, the thin film capacitive element 1 according to this embodiment includes the dielectric layer 5 formed on the lower electrode layer 4.

In this embodiment, the dielectric layer 5 is formed of a dielectric material containing a bismuth layer structured compound represented by the stoichiometric compositional formula: $SrBi_4Ti_4O_{15}$ and having an excellent characteristic as a capacitor material.

The bismuth layer structured compound preferably contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

In this embodiment, the dielectric layer 5 is formed on the lower electrode layer 4 using a metal-organic decomposition process (MOD).

Concretely, a toluene solution of 2-ethyl hexanoate Sr, a 2-ethyl hexanoate solution of 2-ethyl hexanoate Bi and a toluene solution of 2-ethyl hexanoate Ti are mixed so that the mixture contains 1 mole of 2-ethyl hexanoate Sr, 4 moles of 2-ethyl hexanoate Bi and 4 moles of 2-ethyl hexanoate Ti and is diluted with toluene, thereby preparing a constituent solution.

The resultant constituent solution is coated on the lower electrode layer 4 using a spin coating method so as to have a thickness of 100 nm, for example, to form a coating layer.

The thus formed coating layer is dried under a temperature between room temperature and about 400 $^\circ$C, thereby evaporating a solvent contained in the coating layer.

The coating layer is then provisionally baked under an oxygen gas atmosphere at a temperature of about 200 to 700 $^\circ$C. The provisional baking operation is performed at a temperature under which the bismuth layer structured compound contained in the coating layer cannot be crystallized.

Then, the same constituent solution is again applied using a spin coating process onto the thus provisionally baked coating layer so as to have a thickness of 10 nm, for example, to form a coating layer and the coating layer is dried and provisionally baked under an oxygen gas atmosphere at a temperature of about 200 to 700 $^\circ$C.

Further, the same constituent solution is again applied using a spin coating process onto the thus provisionally baked coating layer so as to have a thickness of 10 nm, for example, to form a coating layer and the coating layer is dried and provisionally baked under an oxygen atmosphere at a temperature of about 200 to 700 $^\circ$C.

When the provisional baking operations have been completed in this manner, the provisionally baked coating layers are baked under an oxygen gas atmosphere at a temperature of about 700 to 900 °C, thereby crystallizing the bismuth layer structured compound contained in the coating layers to form the dielectric layer 5 having a thickness of 300 nm, for example.

The thus formed dielectric layer 5 contains a bismuth layer structured compound represented by the stoichiometric compositional formula: $SrBi_4Ti_4O_{15}$.

During the provisional baking and baking processes, the bismuth layer structured compound is oriented in the [001] direction, namely, the $c$ axis direction thereof.

The inventor knew that the degree $F(\%)$ of orientation of a bismuth layer structured compound could be controlled by controlling coating conditions, provisional baking conditions and baking conditions for forming a dielectric layer 5 and in a study conducted by the inventor of the present invention, it was further found that the electrostatic capacitance temperature coefficient of a thin film capacitive element could be changed by controlling the degree $F(\%)$ of $c$ axis orientation of a bismuth layer structured compound contained in a dielectric layer 5. In particular, it was found that in the case where a dielectric layer 5 contained a bismuth layer structured compound having a composition represented by the stoichiometric compositional formula: $SrBi_4Ti_4O_{15}$, the electrostatic capacitance temperature coefficient of a thin film capacitive element could be greatly varied between a plus value and a minus value by controlling the degree $F(\%)$ of $c$ axis orientation of the bismuth layer structured compound.

Therefore, in this embodiment, the coating conditions, provisional baking conditions and baking conditions for forming a dielectric layer 5 are controlled, whereby the degree $F(\%)$ of c axis orientation of a bismuth layer structured compound contained in a dielectric layer 5 is determined so that the thin film capacitive element has a desired electrostatic capacitance temperature coefficient.

As shown in Figure 1, the upper electrode layer 6 is formed of platinum on the dielectric layer 5.

The upper electrode layer 6 made of platinum is formed on the dielectric layer 5 by, for example, using a sputtering process with argon gas as a sputtering gas and setting the temperatures of the support substrate 2, the insulating layer 3, the lower electrode layer 4 and the dielectric layer to room temperature.

As mentioned above, in a study of the inventor of the present invention, it was further found that the electrostatic capacitance temperature coefficient of a thin film capacitive element could be changed by controlling the degree $F(\%)$ of c axis orientation of a bismuth layer structured compound contained in a dielectric layer 5 and in particular, it was found that in the case where a dielectric layer 5 contained a bismuth layer structured compound having a composition represented by the stoichiometric compositional formula: $SrBi_4Ti_4O_{15}$, the electrostatic capacitance temperature coefficient of a thin film capacitive element could be greatly varied between a plus value and a minus value by controlling the degree $F(\%)$ of $c$ axis orientation of the bismuth layer structured compound.

According to this embodiment, since the dielectric layer 5 contains a bismuth layer structured compound having a composition represented by the stoichiometric compositional formula: $SrBi_4Ti_4O_{15}$ and the coating conditions, provisional baking conditions and baking conditions for forming a dielectric layer 5 are controlled, whereby the degree $F(\%)$ of $c$ axis orientation of a bismuth layer structured compound contained in the dielectric layer 5 in the is determined, it is therefore possible to obtain a thin film capacitive element 1 having a desired electrostatic capacitance temperature coefficient without providing a plurality of dielectric layers. It is therefore possible to control the temperature dependency of an electronic circuit into which the thin film capacitive element 1 is incorporated in a desired manner, thereby lowering the temperature dependency of the electronic device into which the electronic circuit is incorporated.

The present invention has thus been shown and described with reference to a specific preferred embodiment. However, it should be noted that the present invention is in no way limited to the details of the described arrangement but changes and modifications may be made without departing from the scope of the appended claims.

For example, in the above described preferred embodiment, although the dielectric layer 5 of the thin film capacitive element 1 is formed of a dielectric material containing the bismuth layer structured compound having a composition represented by the stoichiometric compositional formula: $SrBi_4Ti_4O_{15}$, it is not absolutely necessary to form the dielectric layer 5 of the thin film capacitive element 1 of a dielectric material containing the bismuth layer structured compound having a composition represented by the stoichiometric compositional formula: $SrBi_4Ti_4O_{15}$ and it is sufficient for a dielectric layer 5 of a thin film capacitive element 1 to be formed of a dielectric material containing a bismuth layer structured compound having a composition represented by the stoichiometric compositional formula: $(Bi_2O_2)^{2+}(A_{m-1}B_mO_{3m+1})^{2-}$ or $Bi_2A_{m-1}B_mO_{3m+3}$, where the symbol $m$ is a positive integer, the symbol $A$ is at least one element selected from a group consisting of sodium (Na), potassium (K), lead (Pb), barium (Ba), strontium (Sr), calcium (Ca) and bismuth (Bi), and the symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined. Further, a dielectric layer 5 of a thin film capacitive element can be formed of a dielectric material containing a bismuth layer structured compound having a composition represented by the stoichiometric compo-

sitional formula: $x$SbBi$_4$Ti$_4$O$_{15}$-(1 - $x$)$M$Bi$_4$Ti$_4$O$_{15}$, where the symbol $M$ is at least one element selected from calcium, barium or lead and the symbol $x$ is equal to or larger than 0 and equal to or smaller than 1. Furthermore, a dielectric layer 5 of a thin film capacitive element can be formed of a dielectric material containing a bismuth layer structured compound having a composition represented by the stoichiometric compositional formula: $x$SbBi$_4$Ti$_4$O$_{15}$-(1 - $x$)$M$Bi$_4$Ti$_4$O$_{15}$, where the symbol $M$ is at least one element selected from calcium, barium or lead and the symbol $x$ is equal to or larger than 0 and equal to or smaller than 1. Moreover, a dielectric layer 5 of a thin film capacitive element can be formed of a dielectric material containing a bismuth layer structured compound having a composition represented by the stoichiometric compositional formula: SrBi$_4$Ti$_4$O$_{15}$.

Further, in the above described preferred embodiment, although the coating layer is formed using a spin coating process when the dielectric layer 5 is to be formed, it is not absolutely necessary to form a coating layer using a spin coating process and a coating layer may be formed using a dip coating process instead of a spin coating process.

Furthermore, in the above described preferred embodiment, although the support substrate 2 of the thin film capacitive element 1 is formed of silicon single crystal, it is not absolutely necessary to form a support substrate 2 of a thin film capacitive element 1 of silicon single crystal and it is possible to employ a support substrate 2 formed of single crystal having a small lattice mismatch such as SrTiO$_3$ single crystal, MgO single crystal, LaAlO$_3$ single crystal or the like, an amorphous material such as glass, fused silica, SiO$_2$/Si or the like, or another material such as ZrO$_2$/Si, CeO$_2$/Si or the like.

Moreover, in the above described preferred embodiment, although the lower electrode layer 4 of the thin film capacitive element 1 is formed of platinum, it is not absolutely necessary to form a lower electrode layer 4 of a thin film capacitive element 1 of platinum and it is possible to form a lower electrode layer 4 of a thin film capacitive element 1 of a conductive oxide such as SrMoO$_3$, SrRuO$_3$, CaRuO$_3$, SrVO$_3$, SrCrO$_3$, SrCoO$_3$, LaNiO$_3$, Nb doped SrTiO$_3$ or the like, a noble metal such as lutetium, gold, palladium, silver or the like, an alloy of these, conductive glass such as ITO or the like, a base metal such as nickel, copper or the like or an alloy of these, or the like. In the case where the support substrate 2 is formed of a material having a small lattice mismatch, it is preferable for a lower electrode layer 4 of a thin film capacitive element 1 to be formed of a conductive oxide such as CaRuO$_3$, SrRuO$_3$ or the like, or a noble metal such as platinum, lutetium or the like.

Further, in the above described preferred embodiment, although the lower electrode layer 4 of the thin film capacitive element 1 is formed using a sputtering process, it is not absolutely necessary to form a lower electrode layer 4 of a thin film capacitive element 1 using a sputtering process and a lower electrode layer 4 of a thin film capacitive element 1 can be formed using any of other thin film forming processes such as a vacuum deposition process, a pulsed laser deposition process (PLD), a metal organic chemical vapor deposition process (MOCVD), a chemical solution deposition process (CSD process) and the like.

Furthermore, in the above described preferred embodiment, although the dielectric layer 5 of the thin film capacitive element 1 is formed using a metal-organic decomposition process (MOD), it is not absolutely necessary to form a dielectric layer 5 of a thin film capacitive element 1 using a metal-organic decomposition process (MOD) and a dielectric layer 5 of a thin film capacitive element 1 can be formed using any of other thin film forming processes such as a vacuum deposition process, a sputtering process, a pulsed laser deposition process (PLD), a metal organic chemical vapor deposition process (MOCVD), another chemical solution deposition process (CSD process) such as a sol-gel process or the like. In order to improve the degree $F$ of the $c$ axis orientation of a bismuth layer structured compound contained in a dielectric layer 5, it is preferable to form a dielectric layer 5 using a metal organic chemical vapor deposition process, a pulsed laser deposition process (PLD) or a vacuum deposition process and on the other hand, in order to lower the degree $F$ of the $c$ axis orientation of a bismuth layer structured compound contained in a dielectric layer 5, it is preferable to form a dielectric layer 5 using a chemical solution deposition process (CSD process) such as a metal-organic decomposition process (MOD) and a sol-gel process or the like.

Moreover, in the above described preferred embodiment, although a constituent solution is applied onto the lower electrode layer 4 using a spin coating process when the dielectric layer 5 is to be formed, it is not absolutely necessary to apply a constituent solution onto a lower electrode layer 4 using a spin coating process and it is possible to apply a constituent solution onto a lower electrode layer 4 using any of other coating processes such as a dip coating process, a spray coating process or the like.

Further, in the above described preferred embodiment, although the upper electrode layer 6 of the thin film capacitive element 1 is formed of platinum, it is not absolutely necessary to form an upper electrode layer 6 of a thin film capacitive element 1 of platinum and an upper electrode layer 6 of a thin film capacitive element 1 can be formed of a conductive oxide such as NdO, NbO, ReO$_2$, RhO$_2$, OsO$_2$, IrO$_2$, RuO$_2$, ReO$_3$, SrMoO$_3$, SrRuO$_3$, CaRuO$_3$, SrVO$_3$, SrCrO$_3$, SrCoO$_3$, LaNiO$_3$, Nb doped SrTiO$_3$ or the like, a noble metal such as lutetium, gold, palladium, silver or the like, an alloy of these, conductive glass such as ITO or the like, a base metal such as nickel, copper or the like or an alloy of these.

Furthermore, in the above described preferred embodiment, although the upper electrode layer 6 of the thin film capacitive element 1 is formed using a sputtering process, it is not absolutely necessary to form an upper electrode layer 6 of a thin film capacitive element 1 using a sputtering process and an upper electrode layer 6 of a thin film capacitive element 1 can be formed using any of other thin film forming processes such as a vacuum deposition process, a pulsed laser deposition process (PLD), a metal organic chemical vapor deposition process (MOCVD), a chemical solution deposition process (CSD process) and the like.

According to the present invention, it is possible to provide a thin film capacitive element which can be made thin and has an excellent temperature compensating characteristic, and an electronic circuit and an electronic device including the thin film capacitive element.

## Claims

1. A thin film capacitive element including between a first electrode layer and a second electrode layer a dielectric layer formed of a dielectric material containing a bismuth layer structured compound having a composition represented by the stoichiometric compositional formula: $(Bi_2O_2)^{2+}$ $(A_{m-1}B_mO_{3m+1})^{2-}$ or $Bi_2A_{m-1}B_mO_{3m+3}$, where a symbol $m$ is a positive integer, a symbol $A$ is at least one element selected from a group consisting of sodium (Na), potassium (K), lead (Pb), barium (Ba), strontium (Sr), calcium (Ca) and bismuth (Bi), and a symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined.

2. A thin film capacitive element in accordance with Claim 1, wherein an electrostatic capacitance temperature coefficient of the bismuth layer structured compound falls in the range of from 1000 ppm/K to -700 ppm/K.

3. A thin film capacitive element in accordance with Claim 1, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

4. A thin film capacitive element in accordance with Claim 2, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

5. A thin film capacitive element including a dielectric layer formed of a dielectric material containing a bismuth layer structured compound having a composition represented by the stoichiometric compositional formula: $xSbBi_4Ti_4O_{15}$-(1-$x$)$MBi_4Ti_4O_{15}$ between a first electrode layer and a second electrode layer, where a symbol $M$ is at least one element selected from calcium, barium or lead and a symbol $x$ is equal to or larger than 0 and equal to or smaller than 1.

6. A thin film capacitive element in accordance with Claim 5, wherein the dielectric layer contains a bismuth layer structured compound having a composition represented by the stoichiometric compositional formula: $SrBi_4Ti_4O_{15}$.

7. A thin film capacitive element in accordance with Claim 6, wherein an electrostatic capacitance temperature coefficient of the bismuth layer structured compound falls in the range of from 800 ppm/K to -150 ppm/K.

8. A thin film capacitive element in accordance with Claim 5, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

9. A thin film capacitive element in accordance with Claim 6, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

10. A thin film capacitive element in accordance with Claim 7, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

11. An electronic circuit including a thin film capacitive element including a dielectric layer formed of a dielectric material containing a bismuth layer structured compound having a composition represented by the stoichiometric compositional formula: $(Bi_2O_2)^{2+} (A_{m-1}B_mO_{3m+1})^{2-}$ or $Bi_2A_{m-1}B_mO_{3m+3}$ between a first electrode layer and a second electrode layer, where a symbol $m$ is a positive integer, a symbol $A$ is at least one element selected from a group consisting of sodium (Na), potassium (K), lead (Pb), barium (Ba), strontium (Sr), calcium (Ca) and bismuth (Bi), and a symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined.

12. An electronic device including a thin film capacitive element including a dielectric layer formed of a dielectric material containing a bismuth layer structured compound having a composition represented by the stoichiometric compositional formula: $(Bi_2O_2)^{2+} (A_{m-1}B_mO_{3m+1})^{2-}$ or $Bi_2A_{m-1}B_mO_{3m+3}$ between a first electrode layer and a second electrode layer, where a symbol m is a positive integer, a symbol $A$ is at least one element selected from a group consisting of sodium (Na), potassium (K), lead (Pb), barium (Ba), strontium (Sr), calcium (Ca) and bismuth (Bi), and a symbol $B$ is at least one element selected from a group consisting of iron (Fe), cobalt (Co), chromium (Cr), gallium (Ga), titanium (Ti), niobium (Nb), tantalum (Ta), antimony (Sb), vanadium (V), molybdenum (Mo) and tungsten (W) and when the symbol $A$ and/or $B$ designates two or more elements, the ratio of the elements is arbitrarily determined.

13. An electronic device in accordance with Claim 12, wherein an electrostatic capacitance temperature coefficient of the bismuth layer structured compound falls in the range of from 1000 ppm/K to -700 ppm/K.

14. An electronic device in accordance with Claim 12, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

15. An electronic device in accordance with Claim 13, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

16. An electronic device including a thin film capacitive element including between a first electrode layer and a second electrode layer a dielectric layer formed of a dielectric material containing a bismuth layer structured compound having a composition represented by the stoichiometric compositional formula: $xSbBi_4Ti_4O_{15}$-$(1 - x)MBi_4Ti_4O_{15}$ between a first electrode layer and a second electrode layer, where a symbol $M$ is at least one element selected from calcium, barium or lead and a symbol $x$ is equal to or larger than 0 and equal to or smaller than 1.

17. An electronic device in accordance with Claim 16, wherein the dielectric layer contains a bismuth layer structured compound having a composition represented by the stoichiometric compositional formula: $SrBi_4Ti_4O_{15}$.

18. An electronic device in accordance with Claim 17, wherein an electrostatic capacitance temperature coefficient of the bismuth layer structured compound falls in the range of from 800 ppm/K to -150 ppm/K.

19. An electronic device in accordance with Claim 16, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

20. An electronic device in accordance with Claim 17, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

**21.** An electronic device in accordance with Claim 18, wherein the bismuth layer structured compound further contains at least one rare-earth element selected from a group consisting of scandium (Sc), yttrium (Y), lanthanum (La), cerium (Ce), praseodymium (Pr), neodymium (Nd), promethium (Pm), samarium (Sm), europium (Eu), gadolinium (Gd), terbium (Tb), dysprosium (Dy), holmium (Ho), erbium (Er), thulium (Tm), ytterbium (Yb) and lutetium (Lu).

FIG. 1

## INTERNATIONAL SEARCH REPORT

| | International application No. |
| --- | --- |
| | PCT/JP2004/001979 |

**A. CLASSIFICATION OF SUBJECT MATTER**
Int.Cl⁷ H01L27/04, H01L27/10, H01G4/33, H01G4/12, C04B35/453, C01G29/00

According to International Patent Classification (IPC) or to both national classification and IPC

**B. FIELDS SEARCHED**

Minimum documentation searched (classification system followed by classification symbols)
Int.Cl⁷ H01L27/04, H01L27/10, H01G4/33, H01G4/12, C04B35/453, C01G29/00

Documentation searched other than minimum documentation to the extent that such documents are included in the fields searched

| | | | |
| --- | --- | --- | --- |
| Jitsuyo Shinan Koho | 1922-1996 | Jitsuyo Shinan Toroku Koho | 1996-2004 |
| Kokai Jitsuyo Shinan Koho | 1971-2004 | Toroku Jitsuyo Shinan Koho | 1994-2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2000-169297 A (Sharp Corp.), 20 June, 2000 (20.06.00), | 1,5-6,11-12, 16-17 |
| Y | Par. Nos. [0008] to [0009], [0024] & US 2002/153543 A1 | 2-4,7-10, 13-15,18-21 |
| X | JP 10-56142 A (Oki Electric Industry Co., Ltd.), 24 February, 1998 (24.02.98), | 1,5-6,11-12, 16-17 |
| Y | Par. Nos. [0020] to [0035] & EP 810666 A1 | 2-4,7-10, 13-15,18-21 |
| Y | JP 9-25124 A (Mitsubishi Materials Corp.), 28 January, 1997 (28.01.97), Par. No. [0026] & US 5807495 A | 2-4,7-10, 13-15,18-21 |

☒ Further documents are listed in the continuation of Box C. ☐ See patent family annex.

| | |
| --- | --- |
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| 13 May, 2004 (13.05.04) | 01 June, 2004 (01.06.04) |

| Name and mailing address of the ISA/ | Authorized officer |
| --- | --- |
| Japanese Patent Office | |
| Facsimile No. | Telephone No. |

Form PCT/ISA/210 (second sheet) (January 2004)

14

**INTERNATIONAL SEARCH REPORT**

International application No.

PCT/JP2004/001979

C (Continuation). DOCUMENTS CONSIDERED TO BE RELEVANT

| Category* | Citation of document, with indication, where appropriate, of the relevant passages | Relevant to claim No. |
|---|---|---|
| Y | JP 9-31635 A (Mitsubishi Materials Corp.), 04 February, 1997 (04.02.97), Par. No. [0022] & US 5807495 A | 2-4,7-10, 13-15,18-21 |
| Y | JP 7-201225 A (Matsushita Electric Industrial Co., Ltd.), 04 August, 1995 (04.08.95), Par. Nos. [0004] to [0032] (Family: none) | 2,4,7,10,13, 15,18,21 |
| Y | JP 6-305817 A (TDK Corp.), 01 November, 1994 (01.11.94), Par. Nos. [0008] to [0025] (Family: none) | 2,4,7,10,13, 15,18,21 |

Form PCT/ISA/210 (continuation of second sheet) (January 2004)